# EUROPÄISCHE PATENTSCHRIFT

(11) **EP 1 200 223 B1**
(45) Veröffentlichungstag und Bekanntmachung des Hinweises auf die Patenterteilung: **03.11.2004**
(21) Anmeldenummer: 00949274.5
(22) Anmeldetag: 06.07.2000
(51) Int. Cl.: B23K 3/06

(54) **DRUCKCHIP FÜR EINEN NACH DEM TINTENDRUCKPRINZIP ARBEITENDEN DRUCKKOPF**
PRINT CHIP FOR A PRINTING HEAD WORKING ACCORDING TO THE INK PRINTING PRINCIPLE
PUCE D'IMPRESSION POUR TETE D'IMPRESSION FONCTIONNANT SELON LE PRINCIPE D'IMPRESSION A ENCRE

(30) Priorität: 06.07.1999 DE 19931110
(43) Veröffentlichungstag der Anmeldung: 02.05.2002
(73) Patentinhaber: Ekra Eduard Kraft GmbH, 74357 Bönnigheim (DE)
(72) Erfinder: WEHL, Wolfgang, D-74080 Heilbronn (DE); WILD, Jörg, D-74081 Heilbronn (DE); KRAUSE, Peter, D-15236 Frankfurt/Oder (DE)
(74) Vertreter: Grosse, Rainer, Dipl.-Ing.
(86) Internationale Anmeldenummer: PCT/EP2000/006405
(87) Internationale Veröffentlichungsnummer: WO 2001/002122

(56) Entgegenhaltungen:
- EP-A- 0 390 346
- EP-A- 0 434 946
- EP-A- 0 678 387
- EP-A- 0 895 866
- EP-A- 0 917 956
- WO-A-97/34769
- GB-A- 2 297 725
- US-A- 4 835 554
- US-A- 5 810 988
- PATENT ABSTRACTS OF JAPAN vol. 1999, no. 04, 30. April 1999 (1999-04-30) & JP 11 000992 A (RICOH CO LTD), 6. Januar 1999 (1999-01-06)
- PATENT ABSTRACTS OF JAPAN vol. 1999, no. 03, 31. März 1999 (1999-03-31) & JP 10 315461 A (SEIKO EPSON CORP), 2. Dezember 1998 (1998-12-02)
- PATENT ABSTRACTS OF JAPAN vol. 1998, no. 09, 31. Juli 1998 (1998-07-31) & JP 10 095113 A (SEIKO EPSON CORP), 14. April 1998 (1998-04-14)

## Beschreibung

Die Erfindung geht aus von einem Druckchip für einen nach dem Tintendruckprinzip arbeitenden Druckkopf, gemäß Oberbegriff des Anspruchs 1, siehe z.B. WO 9734769.

Aus der DE 44 43 254 C1 ist ein gattungsgemäßer Druckchip bekannt. Dieser weist eine Mediumkammer auf, die von einer Ausnehmung in einer Glasplatte gebildet wird, die auch als Trägerplatte bezeichnet wird. Die Ausnehmung ist so tief in die Glasplatte eingebracht, dass der Boden der Ausnehmung als auslenkbare Membran dient, die somit eine Wandung der Mediumkammer bildet. In der Mediumkammer mündet ein Kanal für die Zuführung einer auszuspritzenden Tinte. Ferner ist eine Ausspritzöffnung vorgesehen, die mit der Mediumkammer verbunden ist. Die in der Glasplatte eingebrachten Ausnehmungen werden von einer Mittelplatte verschlossen. Der bekannte Druckchip ist also aus zwei aufeinanderliegenden Substratteilen gebildet, wobei zumindest das eine Substratteil aus Glas besteht.

Nachteilig bei diesem bekannten Druckchip ist, dass er zum Ausspritzen von sehr heißen Medien, deren Temperatur über 500°C liegt, mangels Wärmebeständigkeit nicht geeignet ist.

Es ist daher Aufgabe der Erfindung, einen Druckchip der eingangs genannten Art anzugeben, der diesen Nachteil nicht aufweist.

Diese Aufgabe wird mit einem Druckchip für einen nach dem Tintendruckprinzip arbeitenden Druckkopf gelöst, wobei der Druckchip die Merkmale des Anspruchs 1 aufweist. Der erfindungsgemäße Druckchip zeichnet sich durch eine hohe Betriebssicherheit aus, wenn Medien mit Temperaturen bis über 1000°C verspritzt werden. Mit den bekannten Glas umfassenden Druckchips können derartig heiße Medien nicht verspritzt werden, da bei diesen Temperaturen eine Aufweichung des Glases erfolgt, so dass die Membran beschädigt wird und/oder nicht mehr reproduzierbar ausgelenkt werden kann, wodurch ein genaues Tropfenvolumen nicht mehr aus der Ausspritzöffnung ausgebracht werden kann. Der erfindungsgemäße Druckchip zeichnet sich auch dadurch aus, dass das einkristalline Silizium nach bekannten und bewährten Fertigungsverfahren bearbeitet werden kann, um die Mediumkammer und die übrigen Kanäle beziehungsweise die Ausspritzöffnung herstellen zu können.

Für die Herstellung ergibt sich daraus der Vorteil, dass von einer Seite an den Substratteilen die notwendigen Ausnehmungen für die Mediumkammer und die Kanäle sowie die Ausspritzöffnung eingebracht werden können. Durch Aufeinanderlegen der Substratteile werden die Ausnehmungen dann verschlossen. Der aus zwei aufeinanderliegenden Substratteilen bestehende Druckchip ist somit einfach und kostengünstig herstellbar.

Nach einem besonders bevorzugten Ausführungsbeispiel ist der Zuführkanal, die Mediumkammer und die Ausspritzöffnung so in dem Druckchip angeordnet, dass das auszuspritzende Medium abwechselnd durch die Substratteile fließt. Vorteilhaft ist hierbei, dass sich die Ausnehmungen zumindest für die Mediumkammer, den Zuführkanal und Ausspritzöffnung in den beiden Substratteilen durch unterschiedliche Fertigungsverfahren herstellen lassen. So kann beispielsweise eines der Substratteile durch anisotropes Nassätzen und das andere Substratteil durch Trockenätzen oder ein anderes Material abtragendes Verfahren bearbeitet werden, um die Ausnehmungen einzubringen. Durch Verdrehen der (100)-Siliziumkristallebene um 45° eines Substratteile gegenüber dem anderen Substratteils können beim anisotropen Nassätzen sämtliche Ausnehmungen strömungsgünstig ausgebildet werden. Da beide Substratteile aus Silizium hergestellt sind, das sehr gut Wärmeleitfähig ist, kommt es auf Grund von Wärmeausdehnung dennoch nicht zu Verspannungen in dem Druckchip.

Bei einem bevorzugten Ausführungsbeispiel ist vorgesehen, dass in dem Druckchip eine Mediumversorgungskammer liegt, mit der der Zuführkanal verbunden ist. Somit kann ein hochintegrierter Druckchip bereitgestellt werden, in dem alle wesentlichen Funktionseinheiten vorhanden sind. Gegebenenfalls wäre es jedoch auch denkbar, die Mediumversorgungskammer, die auch als Vorratskammer bezeichnet werden kann, in einem separaten Bauteil auszubilden, das dann an dem Druckchip befestigbar ist. Wird jedoch die Mediumversorgungskammer im Druckchip realisiert, können sämtliche funktionswesentlichen Teile durch einfach herstellbare Ausnehmungen in den Substratteilen realisiert werden.

Bei einem bevorzugten Ausführungsbeispiel ist vorgesehen, dass die Druckchipoberflächen, insbesondere die mit dem heißen Medium in Berührung kommenden, mit einer hochtemperaturbeständigen Beschichtung versehen sind. Somit kann das heiße, flüssige Medium das Druckchipsubstrat auch über eine lange Lebensdauer des Druckchips diesen nicht beschädigen.

Vorzugsweise ist vorgesehen, dass die Druckchipoberflächen, insbesondere die mit dem heißen Medium in Berührung kommenden, durch thermisches Oxid passiviert sind. Vorzugsweise wird das thermische Oxid an den Kanalwänden und der Wandung der Mediumkammer angebracht. Insbesondere werden also die Druckchipoberflächen mit thermischem Oxid passiviert, an denen das heiße Medium vorbeifließt.

Bei einem besonders bevorzugten Ausführungsbeispiel sind die beiden Substratteile durch Silicon-Fusion-Bonding untrennbar miteinander verbunden. Diese nur bei Silizium-Silizium anwendbare Verbindungsmethode gewährleistet eine sichere Verbindung beider Substratteile auch bei Betriebstemperaturen weit über 1000°C. Somit zeichnet sich der Druckchip gegenüber bekannten Druckchips auch durch eine temperaturfeste Verbindung beider Substratteile miteinander aus.

Nach einem bevorzugten Ausführungsbeispiel werden die Ausnehmung für die Mediumkammer, der Zuführkanal, die Ausspritzöffnung und die Mediumversorgungskammer durch ein anisotropes Nass- oder Trockenätzverfahren hergestellt, wobei insbesondere das anisotrope Nassätzen mit Kaliumhydroxid (KOH) bevorzugt wird. Selbstverständlich sind andere basischen Ätzlösungen, insbesondere Alkalilaugen, verwendbar. Durch das anisotrope Ätzen in einkristallinem Silizium mit (100)-Orientierung entstehen die Ausnehmungen für die Kanäle und die Mediumkammer immer mit vier pyramidal schräg verlaufenden Seitenwandungen an den (111)-Kristallebenen. Ihr Winkel zu der (100)-Kristallebene der Substratoberfläche des Siliziums beträgt allseitig 54,7°. Die Maße der Ausnehmungen sind bei diesem Ätzverfahren sehr genau herstellbar. Insbesondere in dem Substratteil, welches die Ausnehmung für die Mediumkammer aufweist, bietet dies den Vorteil, dass die Membranfläche sehr genau hergestellt werden kann, wenn diese Membranfläche durch den Boden der Ausnehmung gebildet wird. Die Membranfläche ist somit lediglich abhängig von der Öffnungsweite der Ätzmaske sowie der zu ätzenden Tiefe für die Ausnehmung. Dadurch, dass der Winkel der Seitenwandungen immer denselben Wert aufweist, kann somit in Abhängigkeit der Öffnungsweite der Lochmaske und der Tiefe der Ausnehmung die wirksame Membranfläche besonders genau hergestellt werden. Sind mehrere Mediumkammern mit jeweils einer auslenkbaren Membran vorgesehen, weisen bei diesem Herstellverfahren sämtliche Membranen im wesentlichen die selbe Fläche auf, so dass bei gleichem Auslenkweg der Membran von jeder Kammer die gleiche Tropfengröße ausgebracht werden kann. Insbesondere zeichnet sich also der Druckchip durch hochgenaue Tropfenvolumen aus, die ausgespritzt werden können.

In bevorzugter Ausführungsform weisen die Mediumkammer, der Zuführkanal und die Ausspritzöffnung -in Flussrichtung des Mediums gesehen- einen trapezförmigen oder V-förmigen Querschnitt auf. Durch die Wahl des einkristallinen (100)-Siliziums können diese Querschnitte sehr genau hergestellt werden, da -wie vorstehend erwähnt- die Seitenwandungen immer einen Winkel von 54,7° mit der (100)-Kristallebene einschließen.

Vorzugsweise ist auch vorgesehen, dass die Mediumkammer -in Draufsicht gesehen- rechteckig ausgebildet ist und dass der Zuführkanal so in der Mediumkammer mündet und die Ausspritzöffnung so mit der Mediumkammer verbunden ist, dass diese im wesentlichen diagonal durchströmt wird. Damit wird in besonders vorteilhafter Weise erreicht, dass sich in der Mediumkammer keine Zonen ausbilden können, in denen das auszuspritzende Medium verharrt, wie dies beispielsweise in den Ecken der rechteckigen Mediumkammer sein könnte. Durch die diagonale Durchströmung der Mediumkammer werden derartige Ablagerungen, die letztlich auch zu einem Verschluss der Mediumkammer führen könnten, auf sichere Art und Weise vermieden. Außerdem ist durch das diagonale Durchströmen der Mediumkammer gewährleistet, dass im Medium vorliegende Gaseinschlüsse sicher ausgespült werden. Natürlich könnte die Mediumkammer -in Draufsicht gesehen- auch quadratisch vorliegen.

Nach einem bevorzugten Ausführungsbeispiel werden die Mediumkammer, der Zuführkanal, die Ausspritzöffnung und die Mediumversorgungskammer von der (100)-Kristallebene oder einer parallel dazu liegenden Ebene des Siliziums her eingebracht, so dass die Seitenwandungen für diese Ausnehmungen in dem vorstehend erwähnten Winkel von 54,7° vorliegen.

Wie vorstehend erwähnt, wird in bevorzugter Ausführungsform die Membran durch den Boden der Ausnehmung gebildet. Die Ätzzeit beziehungsweise Ätztiefe zur Herstellung dieser Ausnehmung wird dabei so bemessen, dass die Membran vorzugsweise eine Dicke von zirka 20 bis 100 µm aufweist.

Bei einem bevorzugten Ausführungsbeispiel weist der Verbindungskanal zumindest einen senkrecht zur zweiten Kristallebene liegenden Teilkanal auf, dessen Mündung die Ausspritzöffnung bildet. Zu der Randfläche des Druckchips führt dann also ein senkrecht zu dieser Randfläche verlaufender Teilkanal zu der Ausspritzöffnung, so dass das Medium aus der Ausspritzöffnung vorzugsweise unter einem Winkel von 90° austritt, wodurch der Tropfen auch auf die gewünschte Stelle an einem zu behandelnden Substrat aufgebracht werden kann.

In bevorzugter Ausführungsform weist der Zuführkanal eine Drosselstelle auf oder ist selbst als Drossel ausgebildet. Die Fließgeschwindigkeit beziehungsweise der Volumenstrom aus der Mediumversorgungskammer in die Mediumkammer kann somit auf besonders einfache Art und Weise eingestellt werden. Beim Auslenken der Membran wird durch die Drossel außerdem verhindert, dass das Medium von der Mediumkammer in die Versorgungskammer zurück gedrückt wird.

Ein besonders bevorzugtes Ausführungsbeispiel zeichnet sich dadurch aus, dass in einem der Substratteile die Mediumkammer und die Versorgungskammer liegen, die gegeneinander durch einen Steg begrenzt sind, und dass der Zuführkanal in dem anderen der Substratteile ausgebildet ist und unter dem freien Ende des Stegs liegt. Somit wird auf einfache Art und Weise eine Überströmmöglichkeit für das Medium von der Versorgungskammer zu der Mediumkammer gebildet, wobei außerdem die Drosselstelle durch den Steg gebildet sein kann.

Bevorzugt wird ein Ausführungsbeispiel des Druckchips, bei dem mehrere Mediumkammern, Zuführkanäle, Verbindungskanäle und Ausspritzöffnungen vorgesehen sind, so dass gleichzeitig oder nacheinander das heiße auszuspritzende Medium ausgebracht werden können.

Bei einem bevorzugten Ausführungsbeispiel weist der Druckchip ein Heizelement auf, das das in der Versorgungskammer liegende Medium heizt, damit es flüssig bleibt und ausgespritzt werden kann. Bevorzugt wird dabei zumindest ein Heizelement am Druckchip angebracht derart, dass es an der Außenseite zumindest eines der Substratteile liegt. Alternativ wäre es auch denkbar, das auszuspritzende Medium bereits so heiß beziehungsweise vorgewärmt in die Versorgungskammer einzubringen, dass eine Heizung am Druckchip selbst nicht notwendig ist. Es kann jedoch auch eine externe Heizeinrichtung, beispielsweise eine Halogenlampe, zur Erwärmung des Mediums vorgesehen sein.

Ein bevorzugtes Ausführungsbeispiel des Druckchips zeichnet sich dadurch aus, dass ein Temperatursensor vorgesehen ist, der insbesondere die Mediumtemperatur überwacht. Hierfür ist insbesondere ein an der Außenseite an zumindest einem der Substratteile liegender Temperatursensor vorgesehen. Durch die Kombination Temperatursensor und Heizelement kann der Druckchip derart auf Temperatur gehalten werden, dass das heiße, flüssige Medium im Druckchip weder unerwünscht erstarrt noch überhitzt wird, so dass permanent gute Ausspritzergebnisse erzielt werden können.

Weitere Ausgestaltungen sind in den Unteransprüchen angegeben.

Der vorstehend beschriebene Druckchip wird bei einer bevorzugten Verwendung insbesondere zum Ausspritzen von heißen, flüssigen Medien verwendet, deren Temperatur bis weit über 1000°C liegen kann. Insbesondere bei den flüssigen Medien, bei denen der Schmelzpunkt in diesem Temperaturbereich liegt, bietet der erfindungsgemäße Druckchip Vorteile, so dass Metalle, Metallverbindungen beziehungsweise - legierungen und sogar niedrig schmelzende Gläser mit dem erfindungsgemäßen Druckchip ausgespritzt werden können.

Die Erfindung wird nachfolgend anhand von Ausführungsbeispielen mit Bezug auf die Zeichnung näher erläutert. Es zeigen:
- Figuren 1 bis 7: in unterschiedlichen Schnittansichten ein erstes Ausführungsbeispiel eines Druckchips,
- Figuren 8 bis 14: in verschiedenen Schnittdarstellungen ein zweites Ausführungsbeispiel eines Druckchips, und
- Figur 15: in schematischer Darstellung ein nach dem Tintendruckprinzip arbeitenden Druckkopf mit einem Druckchip.

In den Figuren sind die Schnittlinien mit römischen Bezugsziffern versehen, die auf die entsprechende die Schnittdarstellung zeigende Figur hinweisen. In der folgenden Figurenbeschreibung wird deshalb darauf nicht weiter Bezug genommen. Im übrigen sind der Übersichtlichkeit halber in den Schnittdarstellungen die Schnittflächen nicht schraffiert gekennzeichnet.

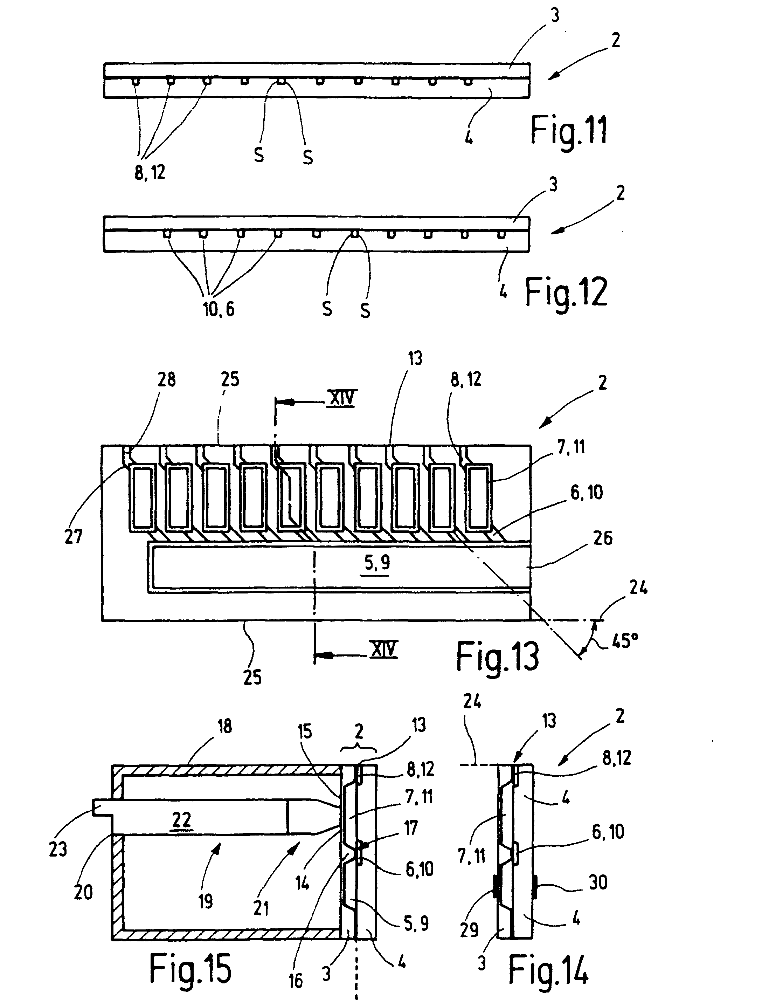

Figur 15 zeigt einen nach dem Tintendruckprinzip arbeitenden Druckkopf 1 in schematischer, stark vereinfachter Darstellung. Der Druckkopf 1 weist einen Druckchip 2 auf, der aus einkristallinem Silizium aufgebaut ist. Der Druckchip 2 umfasst zwei aufeinander liegende Substratteile 3 und 4, die an ihren Berührflächen durch das Silicon-Fusion-Bonding zumindest bereichsweise miteinander fest und untrennbar verbunden sind. In den Substratteilen 3 und 4 sind Ausnehmungen 5 bis 8 eingebracht, wobei die Ausnehmung 5 eine Mediumversorgungskammer 9, die Ausnehmung 6 einen Zuführkanal 10, die Ausnehmung 7 eine Mediumkammer 11 und die Ausnehmung 8 einen Verbindungskanal 12 und einen Ausspritzöffnung 13 bildet. Die Ausnehmungen 5 bis 8 sind jeweils von der gegenüberliegenden Seite des entsprechenden Substratteils 3 beziehungsweise 4 verschlossen, so dass in sich geschlossene Kammern gebildet sind, wobei lediglich die Ausspritzöffnung 13 realisiert ist. Für das auszuspritzende heiße Medium ergibt sich somit eine Flussrichtung von der Versorgungsmediumkammer 9 über den Zuführkanal 10 in die Mediumkammer 11 und den Verbindungskanal 12 zur Ausspritzöffnung 13. Damit das Medium aus der Mediumkammer 11 ausgespritzt werden kann, weist diese eine Wandung der Mediumkammer bildende auslenkbare Membran 14 auf, die von dem Boden 15 der Ausnehmung 7 gebildet wird.

Sämtliche Ausnehmungen 5 bis 8 sind im Querschnitt trapez- oder v-förmig, also wannenartig, wenn sie durch anisotropes Ätzen hergestellt werden. Das heißt, dass vier pyramidal schräg verlaufende Seitenwände S einer Ausnehmung 5 bis 8 zur (100)-Kristallebene unter einem Winkel von 54,7° liegen. Somit wird ersichtlich, dass sämtliche Ausnehmungen 5 bis 8 von der (100)-Kristallebene aus in die Substratteile 3 und 4 eingebracht sein können. Werden andere Ätzverfahren oder Material abtragende Verfahren angewandt, können die Seitenwände S auch in einem anderen Winkel, insbesondere senkrecht, zur (100)-Kristallebene liegen. Die Ausnehmungen können bei Herstellung mit anderen Verfahren -in Draufsicht gesehen- auch andere als rechteckige Konturen aufweisen.

Zwischen der Versorgungsmediumkammer 9 und der Mediumkammer 11 ist ein Steg 16 ausgebildet, der die beiden Kammern 9 und 11 voneinander trennt. Das freie Ende des Steges 16 liegt über der Ausnehmung 6, so dass der Zuführkanal 10 realisiert und die Überströmmöglichkeit für das Medium von der Versorgungsmediumkammer 9 zu der Mediumkammer 11 gegeben ist. Somit wird auch klar, dass der Zuführkanal 10 eine Drosselstelle 17 aufweist beziehungsweise als Drossel ausgebildet ist, wobei die Drosselstelle 17 vorzugsweise durch das freie Ende des Steges 16 gebildet wird.

An dem Druckchip 2 ist noch ein Tragkörper 18 angebracht, in dem ein Aktor 19 angeordnet ist. Das linke Ende des Aktors 19 ist durch einen Durchbruch 20 im Tragkörper 18 geführt und darin befestigt gehalten. Das rechte freie Ende des Aktors 19 ist mit der Membran 14 verbunden, so dass durch elektrische Ansteuerung des Aktors 19 die Membran in beiden Richtungen ausgelenkt werden kann. Der Aktor 19 ist in bevorzugter Ausführungsform ein piezoelektrisches Element, welches über ein Wärmesperrelement 21 von der im Betrieb des Druckkopfs 1 heißen Membran 14 thermisch entkoppelt ist. Vorzugsweise ist der Aktor 19 mit dem Wärmesperrelement 21 einstückig ausgebildet, wobei die für die Ansteuerung des Aktors 19 notwendigen Elektroden nicht über die gesamte Länge des Aktors 19 geführt sind, so dass das Wärmesperrelement 21 bei einer Spannungsbeaufschlagung der Elektroden nicht aktiviert wird. Der Aktor 19 weist also ein passives Element und ein aktives Element auf, wobei das aktive Element von den Elektroden bedeckt ist, von denen hier lediglich eine Elektrode 22 dargestellt ist, deren Anschluss 23 aus dem Tragkörper 18 herausgeführt ist. Die andere nicht sichtbare Elektrode liegt mit Abstand parallel zur Elektrode 22 und ist deshalb an dem stabförmigen beziehungsweise lamellenförmigen Aktor in Figur 15 nicht sichtbar. Sie besitzt jedoch auch einen Anschluss.

Zur Funktion: Wird der Aktor 19 mit einer entsprechenden Spannung, die auch impulsförmig sein kann, beaufschlagt, wird die Membran nach rechts ausgelenkt, wodurch das Volumen in der Mediumkammer verringert wird, so dass ein Tropfen des Mediums mit einem entsprechenden Volumen aus der Ausspritzöffnung 13 herausgedrückt wird. Damit aus der Mediumkammer das Medium nicht in die Mediumversorgungskammer 9 zurückgedrückt wird, ist die Drosselstelle 17 vorgesehen. Selbstverständlich kann bei Deaktivierung des Aktors beziehungsweise anders gepolter Spannung die Membran 14 auch nach links ausgelenkt werden, so dass Medium aus der Versorgungsmediumkammer 9 in die Mediumkammer 11 über die Drosselstelle 17 eingesaugt werden kann. Zwischen Ausspritzöffnung 13 und Mediumkammer 11 kann gegebenenfalls auch eine Drossel liegen. Bei impulsförmiger Ansteuerung des Aktors 19 ist somit ein hochfrequentes Ausspritzen von Medium aus der Ausspritzöffnung 13 möglich.

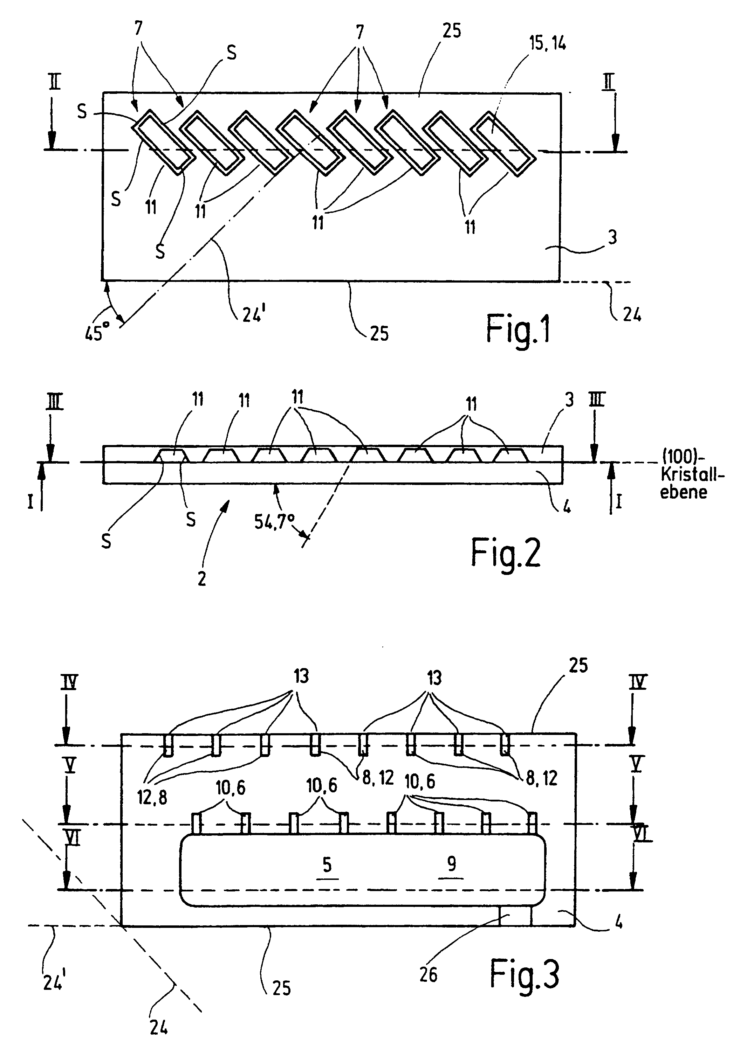

Anhand der Figuren 1 bis 7 wird im Folgenden ein erstes Ausführungsbeispiel eines Druckchips 2 beschrieben. Figur 1 zeigt das eine Substratteil 3 des Druckchips 2, in dem mehrere Ausnehmungen 7 eingebracht sind, die jeweils eine Mediumkammer 11 bilden. Die (100)-Kristallebene liegt hier parallel zur Zeichnungsebene. Eine senkrecht zur (100)-Kristallebene liegende zweite Kristallebene 24, beispielsweise die (011)-Ebene, liegt parallel zu einem seitlichen Rand 25 des Substratteils 3. Es ist ersichtlich, dass die Längserstreckung (Durchflussrichtung) der Mediumkammern 11 etwa in einem Winkel von 45° zu dieser zweiten Ebene 24 liegt. Die Mediumkammern 11 sind -in Draufsicht gesehen- im wesentlichen rechteckig ausgebildet. Sie können selbstverständlich auch quadratisch vorliegen. Die Ausnehmungen 7 für die Mediumkammer 11 sind durch anisotropes Ätzen hergestellt, wodurch sich der vorstehend erwähnte Winkel von 45° der Seitenwandungen S gegenüber der (100)-Ebene ergibt, wie dies in Figur 2 dargestellt ist.

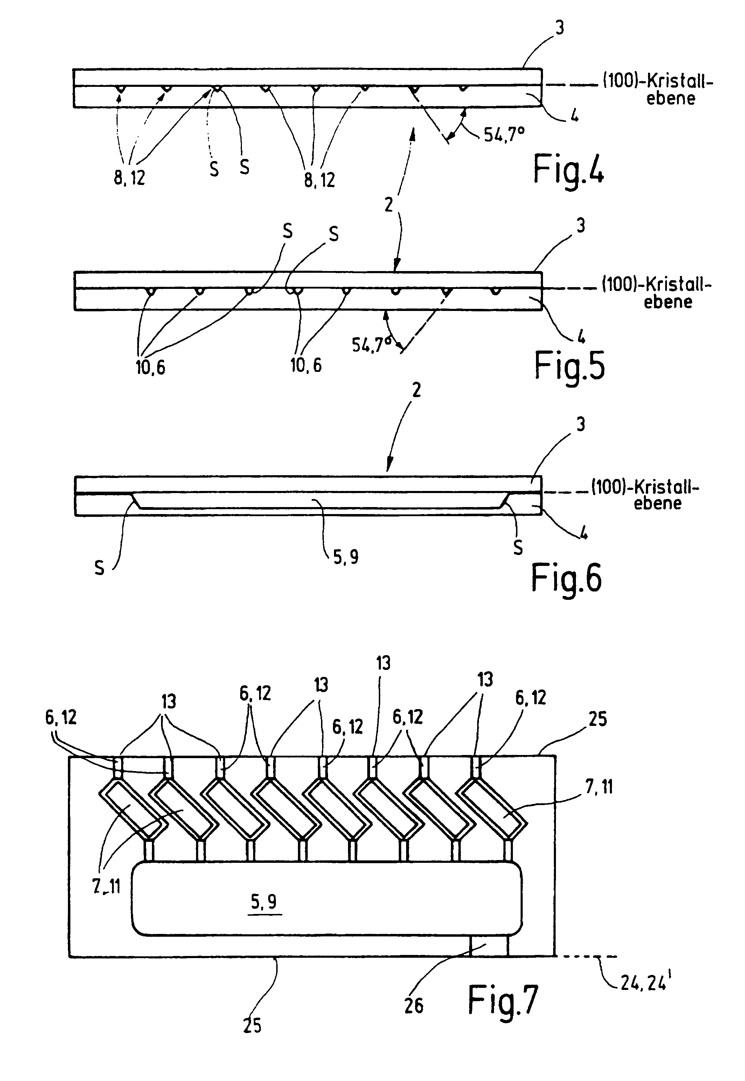

In dem anderen Substratteil 4 (Figur 3), sind die übrigen Ausnehmungen 5, 6 und 8 von der (100)-Kristallebene her eingebracht. Zu der (100)-Ebene des Substratteils 4 liegt senkrecht eine zweite Kristallebene 24', die -liegen beide Substratteile 3 und 4 aufeinander- einen Winkel von 45° mit der zweiten Kristallebene 24 des Substratteils 3 einschließt. Diese zweite Ebene 24' könnte beispielsweise die (001)-Kristallebene sein. Das Substratteil 4 ist beim Einbringen der Ausnehmungen 6 und 8 also gegenüber dem Substratteil 4 um 45° verdreht. Die Ausnehmungen 6 und 8, die die Zuführkanäle 10 beziehungsweise Verbindungskanäle 12 bilden, sind hier versetzt zueinander angeordnet und zwar derart, dass bei aufeinanderliegenden Substratteilen 3 und 4 die Zuführkanäle 10 beziehungsweise Verbindungskanäle 12 jeweils an den Ecken der Mediumkammern 11 zu liegen kommen, wie es insbesondere in der schematischen Draufsicht auf den Druckchip 2 nach Figur 7 zu sehen ist. Die Verbindungskanäle 12 beziehungsweise Zuführkanäle 10 sind in diesem Ausführungsbeispiel etwa senkrecht zu der zweiten Kristallebene 24' ausgerichtet. Durch diese Anordnung wird erreicht, dass das aus der Mediumversorgungskammer 9 strömende Medium die Mediumkammern 11 diagonal durchströmt, da die Längserstreckung der Mediumkammer 11 unter einem Winkel von 45° zur zweiten Kristallebene 24 liegt. Aus Figur 3 ist noch ersichtlich, dass die Versorgungsmediumkammer 9 eine Versorgungsöffnung 26 besitzt, über die ein Medium zugeführt werden kann. Im übrigen sind in den Figuren 1 bis 7 und 15 gleiche beziehungsweise gleichwirkende Teile mit identischen Bezugszeichen versehen. Im gezeigten Ausführungsbeispiel sind die Mediumkammern 11, die Zuführkanäle 10 und die Verbindungskanäle 12 mit ihren Ausspritzöffnungen 13 durch anisotropes Nassätzen gefertigt. Die Mediumversorgungskammer 9 und dies Versorgungsöffnung 26 sind wegen ihrer Geometrie durch ein anderes Material abtragendes Verfahren, insbesondere Ätzverfahren, hergestellt.

Insbesondere aus den Figuren 2, 4 und 5 sind die gegenüberliegenden Seitenwandungen S der Ausnehmungen 6 bis 8 ersichtlich, wobei diese Seitenwandungen einen Winkel von 54,7° zur (100)-Kristallebene einschließen, wie dies beim Herstellen der Ausnehmungen 6 bis 8 durch anisotropes Ätzen im einkristallinen Silizium auftritt. Die Seitenwände S der Ausnehmungen 5 und 26 können mit der (100)-Kristallebene einen nahezu beliebigen Winkel einschließen.

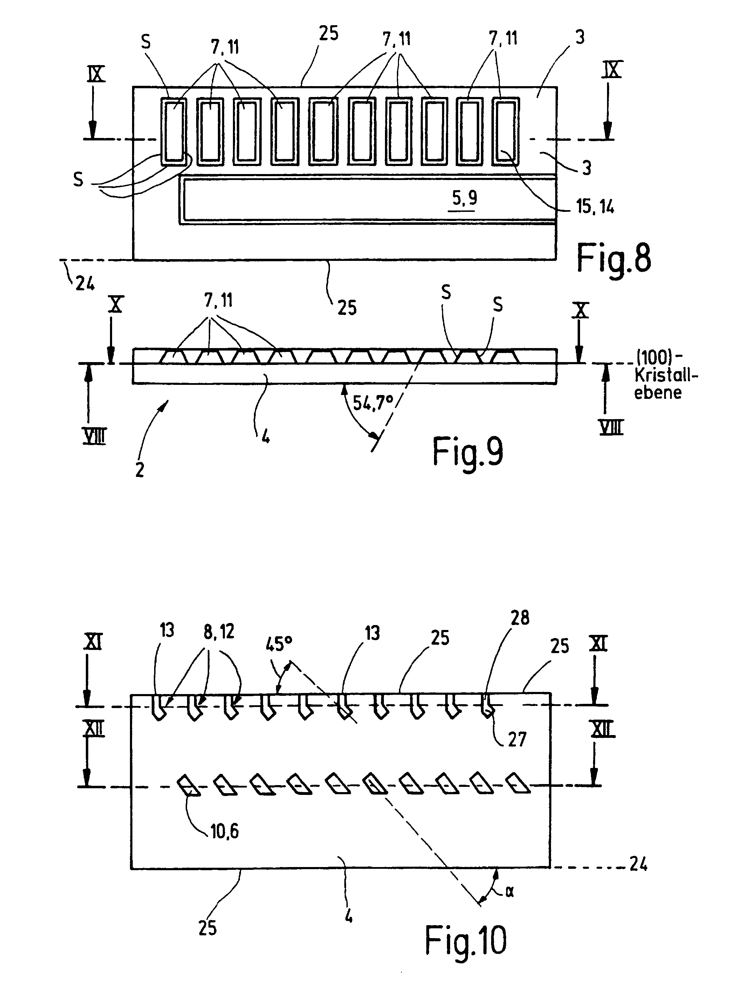

Anhand der Figuren 8 bis 14 wird im Folgenden ein zweites Ausführungsbeispiel eines Druckchips 2 näher erläutert. Gleiche beziehungsweise gleichwirkende Teile wie in den vorhergehend beschriebenen Figuren sind mit identischen Bezugszeichen versehen. Aus Figur 8 ist ersichtlich, dass in dem Substratteil 3 die Mediumkammern 11 beziehungsweise die Ausnehmungen 7 und die Mediumversorgungskammer 9 beziehungsweise die Ausnehmung 5 eingebracht sind. Diese Ausnehmungen 5 und 7 sind durch anisotropes Ätzen in das Substratteil 3 eingebracht. Die Längserstreckung der -in Draufsicht gesehenrechteckigen Mediumkammern 11 liegt hier im wesentlichen senkrecht zur zweiten Kristallebene 24. Entsprechend sind gemäss Figur 10 die Zuführkanäle beziehungsweise Verbindungskanäle in einem Winkel von vorzugsweise 45° zu dieser zweiten Kristallebene 24 ausgerichtet, so dass auch bei diesem Ausführungsbeispiel gewährleistet ist, dass die Mediumkammern 11 im wesentlichen diagonal von dem Medium durchströmt werden. In Figur 10 ist noch dargestellt, dass der Verbindungskanal 12 Teilkanäle 27 und 28 umfasst, die ineinander übergehen, wobei der eine Teilkanal 27 im Winkel von 45° zu der zweiten Kristallebene 24 liegt und der andere Teilkanal 28 im wesentlichen rechtwinklig zu dieser zweiten Kristallebene 24 ausgerichtet ist. Dadurch werden die aus den Ausspritzöffnungen 13 ausgebrachten Tropfen im wesentlichen rechtwinklig zu dieser zweiten Kristallebene 24 ausgespritzt. Die Ausnehmungen 6 und 8 sind in das Substratteil 4 vorzugsweise nicht nach einem anisotropen Ätzverfahren hergestellt, so dass das Substratteil 4 vor dem Herausarbeiten dieser Ausnehmungen nicht um 45° gegenüber dem anderen Substratteil 3 gedreht werden muss. Somit kann der Winkel ä (Figur 10) zwischen den Ausnehmungen 6 beziehungsweise 8 und der zweiten Ebene 24 beliebig gewählt werden, wobei etwa 45° bevorzugt werden.

Insbesondere aus den Figuren 7, 13 und 14 wird folgende Mediumführung klar: Die Ausnehmungen 5 bis 8 sind derart in die Substratteile 3 und 4 eingebracht, dass das Medium die Substratteile 3 beziehungsweise 4 abwechselnd durchströmt. Insbesondere beim Ausführungsbeispiel nach Figur 13 des Druckchips 2 ist dies realisiert. Hier sind die Ausnehmungen 5 bis 8 jeweils abwechselnd in die Substratteile 3 und 4 eingebracht. Beim Ausführungsbeispiel des Druckchips nach Figur 7 sind die zusammenhängenden Ausnehmungen 5 und 6 in dem Substratteil 4 angeordnet. Nachdem das Medium diese beiden Ausnehmungen 5 und 6 durchflossen hat, fließt es in die Mediumkammer 11, die in dem anderen Substratteil 3 angeordnet ist. Danach fließt das Medium wieder in das Substratteil 4 durch die verbindungskanäle 12 zu den Ausspritzöffnungen 13.

Die Ausnehmungen 6 bis 8 beziehungsweise 26 können durch anisotrope Ätzverfahren an den beiden Substratteilen 3 und 4 hergestellt werden, wobei jedoch beim Ätzen und späteren Verbinden darauf geachtet werden muss, dass das entsprechende Substratteil 3 oder 4 um 45° gegenüber dem anderen Substratteil 4 oder 3 orientiert ist, damit auf Grund der (100)-Kristallstruktur diese Ausnehmungen mit der zweiten Kristallebene 24 beziehungsweise 24' den gewünschten Winkel von 45° einschließen. Das heißt, dass die Ätz-Lochmaske für das entsprechende Substratteil 3 oder 4 auf der zu ätzenden Substratoberfläche um 45° gedreht werden muss, damit auf Grund der Kristallorientierung die Ausnehmungen lagerichtig entstehen. Werden für die Ausnehmungen 5 bis beziehungsweise 26 andere Ätzverfahren angewandt, kann die Orientierung der zweiten Kristallebene 24 beziehungsweise 24' unberücksichtigt bleiben. Das jeweils spezifisch vorteilhafte Ätzverfahren wird für die Ausnehmungen 5 bis 8 und 26 gewählt.

Es ist vorgesehen, dass die mit dem Medium in Berührung kommenden Wandungen der Ausnehmungen 5 bis 8 mit einer hochtemperaturfesten Beschichtung versehen sind. Diese Wandungen der Ausnehmungen 5 bis 8 sind in bevorzugter Weise außerdem durch thermisches Oxid passiviert Thermisches Oxid ist sehr dichtes, ideal haftendes Siliziumdioxid, das entsteht, wenn das Silizium bei hohen Temperaturen einer Sauerstoff- oder Wasserdampfatmosphäre ausgesetzt wird.

Ferner ist dem Druckchip 2 eine Heizung 29 (Figur 14) zugeordnet, die an zumindest einem der Substratteile 3 oder 4 angeordnet sein kann. Wie aus Figur 14 hervorgeht, kann die Heizeinrichtung 29 insbesondere im Bereich des Bodens der Ausnehmung 5 vorgesehen sein, damit das in der Versorgungsmediumkammer 9 vorliegende Medium auf Temperatur gehalten werden kann. Selbstverständlich kann jedoch auch an dem Substratteil 4 eine derartige Heizeinrichtung 29 -auch großflächiger- vorgesehen sein. Vorzugsweise wird die Heizeinrichtung 29 als eine hochtemperaturbeständige Widerstandsheizung realisiert, bei der die Widerstände insbesondere aus Hafniumdiborid hergestellt sind. Außerdem kann an dem Druckchip 2 zumindest ein temperaturbeständiger Sensor 30 angebracht sein, der an einem der Substratteile 3 und/oder 4 angeordnet sein kann. Mit dem Temperatursensor 30 und einer Erfassungseinrichtung für das Ausgangssignal des Sensors ist eine Temperaturüberwachung des Druckchips 2 möglich. Durch entsprechende Anordnung an dem Druckchip 2 kann der Temperatursensor 30 auch die Mediumtemperatur messen, insbesondere dann, wenn er in einem sehr dünnwandigen Bereich der Substratteile 3 und 4 liegt, wobei diese dünnwandigen Bereiche, beispielsweise ein Boden einer Ausnehmung 5 bis 8, von dem heißen Medium berührt werden.

Insbesondere eignet sich dieser erfindungsgemäße Druckchip 2 zum Ausspritzen heißer flüssiger Metalle, insbesondere Metalllegierungen und/oder -lote. Selbstverständlich können auch niedrig schmelzende Gläser oder dergleichen ausgespritzt werden. Insbesondere eignet sich der Druckchip 2 für das sogenannte Chip-Size-Packaging (CSP) und bei der Herstellen einer Flip-Chip-Verbindung (FC); bei diesen Verfahren werden Lotbumps auf Chipsubstrate aufgebracht. Auch für ein sogenanntes Rapid-Prototyping-Verfahren, mit dem sich insbesondere mikromechanische Bauelemente durch tropfenweises Aufeinanderspritzen von -auch unterschiedlichen- Materialien herstellen lassen, ist der Druckchip 2 geeignet. Der erfindungsgemäße Druckchip 2 ist also in vielseitigen Produktionsverfahren einsetzbar.

## Patentansprüche

1. Druckchip (2) für einen nach dem Tintendruckprinzip arbeitenden Druckkopf (1), mit zumindest einer eine Mediumkammer (11) bildenden Ausnehmung (7) in dem Druckchip (2), einer eine Wandung der Mediumkammer (11) bildenden auslenkbaren Membran (14), einem in der Mediumkammer (11) mündenden Kanal (10) für die Zuführung eines heiß auszuspritzenden, flüssigen Mediums, und mit einer mit der Mediumkammer (11) verbundenen Ausspritzöffnung (13), wobei der Druckchip (2) ausschließlich aus einkristallinem Silizium hergestellt und aus zumindest zwei aufeinanderliegenden Substratteilen (3,4) gebildet ist, **dadurch gekennzeichnet, dass** der Zuführkanal (10) und ein die Ausspritzöffnung (13) der Mediumkammer (11) verbindender Verbindungskanal (12) um 45° gegenüber einer senkrecht zur (100)-Kristallebene des Siliziumkristalls liegenden zweiten Kristallebene (24,24') verlaufen und dass die Mediumkammer (11) einen Winkel von 45° mit der senkrecht zur (100)-Kristallebene liegenden zweiten Kristallebene (24,24') einschließt und der Zuführkanal (10) und der Verbindungskanal (12) senkrecht zu dieser zweiten Kristallebene (24) liegen, und dass die jeweilige Kristallebene der aneinanderliegenden Oberflächen der aufeinanderliegenden Substratteile (3,4) jeweils der (100)-Kristallebene entsprechen.

2. Druckchip nach Anspruch 1, **dadurch gekennzeichnet, dass** der Zuführkanal (10), die Mediumkammer (11) und die Ausspritzöffnung (13) so in dem Druckchip (2) angeordnet sind, dass das Medium abwechselnd durch die Substratteile (3,4) fließt.

3. Druckchip nach einem der vorhergehenden Ansprüche, **dadurch gekennzeichnet, dass** in dem Druckchip (2) eine Mediumversorgungskammer (9) liegt, mit der der Zuführkanal (10) verbunden ist.

4. Druckchip nach einem der vorhergehenden Ansprüche, **dadurch gekennzeichnet, dass** die Druckchipoberflächen, insbesondere die mit dem heißen Medium in Berührung kommenden, mit einer hochtemperaturbeständigen Beschichtung versehen sind.

5. Druckchip nach einem der vorhergehenden Ansprüche, **dadurch gekennzeichnet, dass** die Druckchipoberflächen, insbesondere die mit dem heißen Medium in Berührung kommenden, durch thermisches Oxid passiviert sind.

6. Druckchip nach einem der vorhergehenden Ansprüche, **dadurch gekennzeichnet, dass** die Substratteile (3,4) durch Silicon-Fusion-Bonding untrennbar miteinander verbunden sind.

7. Druckchip nach einem der vorhergehenden Ansprüche, **dadurch gekennzeichnet, dass** die Ausnehmung (7) für die Mediumkammer (11), der Zuführkanal (10), die Ausspritzöffnung (13) und die Mediumversorgungskammer (9) durch ein anisotropes Nass- oder Trockenätzverfahren hergestellt sind.

8. Druckchip nach einem der vorhergehenden Ansprüche, **dadurch gekennzeichnet, dass** die Mediumkammer (11), der Zuführkanal (10) und die Ausspritzöffnung (13) -in Flussrichtung des Mediums gesehen- einen trapezförmigen oder V-förmigen Querschnitt besitzen.

9. Druckchip nach einem der vorhergehenden Ansprüche, **dadurch gekennzeichnet, dass** die Mediumkammer (11) in Draufsicht rechteckig ausgebildet ist und dass der Zuführkanal (10) so in der Mediumkammer (11) mündet und die Ausspritzöffnung (13) so mit der Mediumkammer (11) verbunden ist, dass diese im Wesentlichen diagonal von dem Medium durchströmt wird.

10. Druckchip nach einem der vorhergehenden Ansprüche, **dadurch gekennzeichnet, dass** die Mediumkammer (11), der Zuführkanal (10), die Ausspritzöffnung (13) und die Mediumversorgungskammer (9) von der (100)-Kristallebene des Siliziumkristalls eingebracht sind.

11. Druckchip nach einem der vorhergehenden Ansprüche, **dadurch gekennzeichnet, dass** der Boden (15) der Ausnehmung (7) die Membran (14) bildet.

12. Druckchip nach einem der vorhergehenden Ansprüche, **dadurch gekennzeichnet, dass** der Verbindungskanal (12) zumindest einen senkrecht zur zweiten Kristallebene (24) liegenden Teilkanal (28) aufweist, dessen Mündung am Rand (25) des Druckchips (2) die Ausspritzöffnung (13) bildet.

13. Druckchip nach einem der vorhergehenden Ansprüche, **dadurch gekennzeichnet, dass** der Zuführkanal (10) eine Drosselstelle (17) aufweist oder als Drossel ausgebildet ist.

14. Druckchip nach einem der vorhergehenden Ansprüche, **dadurch gekennzeichnet, dass** in einem der Substratteile (3,4) die Mediumkammer (11) und die Versorgungskammer (9) liegen, die gegeneinander durch einen Steg (16) begrenzt sind, und dass der Zuführkanal (10) in dem anderen der Substratteile (3,4) ausgebildet ist und unter dem freien Ende des Steges (16) liegt.

15. Druckchip nach einem der vorhergehenden Ansprüche, **gekennzeichnet durch** mehrere Mediumkammern (11), Zuführkanäle (10), Verbindungskanäle (12) und Ausspritzöffnungen (13).

16. Druckchip nach einem der vorhergehenden Ansprüche, **gekennzeichnet durch** zumindest ein Heizelement (29), das an der Außenseite zumindest eines der Substatteile (3,4) liegt.

17. Druckchip nach einem der vorhergehenden Ansprüche, **gekennzeichnet durch** zumindest einen an der Außenseite an zumindest einem der Substratteile (3,4) liegenden Temperatursensor (30).

18. Druckchip nach einem der vorhergehenden Ansprüche, **dadurch gekennzeichnet, dass** die Membran (14) eine Dicke von zirka 20 bis 100 µm aufweist.

19. Druckchip nach Anspruch 7, **dadurch gekennzeichnet, dass** -wenn die Ausnehmungen (5 bis 8,26) in beiden Substratteilen (3,4) durch anisotropes Ätzen eingebracht sind- die beiden Substratteile (3,4) beim Ätzen und beim späteren Verbinden, bezogen auf die senkrecht zur (100)-Substratoberfläche liegenden (100)-Kristallebenen, um 45° zueinander verdreht sind.

20. Verwendung eines Druckchips nach einem der Ansprüche 1 bis 19 zum Ausspritzen von bis über 1000°C heißen, flüssigen Medien.

21. Druckkopf, der nach dem Tintendruckprinzip arbeitet, **gekennzeichnet durch** einen Druckchip nach einem der Ansprüche 1 bis 19.

## Claims

1. Print chip (2) for a printhead (1) functioning according to the ink-jet principle with at least one recess (7) in the print chip (2) which forms a medium chamber (11), an actuatable membrane (14) which forms a wall of the medium chamber (11), a channel (10) opening into the medium chamber (11) for admitting a liquid medium which is to be jetted hot and with a jet opening (13) connected to the medium chamber (11), with the printing chip (2) being produced exclusively from monocrystaline silicon and being formed of at least two substrate portions (3,4) lying one on the other, **characterized in that** the admission channel (10) and a connecting channel (12) that connects the jet opening (13) with the medium chamber (11) run at 45° with respect to a second crystal plane (24,24') lying vertical to the (100) crystal plane of the silicon crystal and that the medium chamber (11) encloses an angle of 45° with the second crystal plane (24,24') which lies vertical to the (100) crystal plane of the silicon crystal, and the admission channel (10) and the connecting channel (12) are vertical to this second crystal plane (24), and that the respective crystal plane of the adjoining surfaces of the substrate portions (3,4) which lie one on the other correspond respectively to the (100) crystal plane.

2. Print chip according to claim 1 **characterized in that** the admission channel (10), the medium chamber (11), and the jet opening (13) are arranged in the printing chip (2) such that the medium flows in turns through substrate parts (3,4).

3. Print chip according to one of the preceding claims **characterized in that** situated in the print chip (2) is a medium supply chamber (9) to which the admission channel (10) is connected.

4. Print chip according to one of the preceding claims **characterized in that** the print chip surfaces, in particular those that come into contact with the hot medium, are provided with a coating resistant to high temperatures.

5. Print chip according to one of the preceding claims **characterized in that** the print chip surfaces, in particular those that come into contact with the hot medium are passivated through thermal oxide.

6. Print chip according to one of the preceding claims **characterized in that** substrate portions (3,4) are inseparably connected to each other through silicon fusion bonding.

7. Print chip according to one of the preceding claims **characterized in that** the recess (7) for the medium chamber (11), the admission channel (10), the jet opening (13), and the medium supply chamber (9) are produced through an anistropic wet or dry etching process.

8. Print chip according to one of the preceding claims **characterized in that** the medium chamber (11), the admission channel (10), and the jet opening (13) -viewed in the flow direction of the medium- have a trapezoidal or V-shaped cross section.

9. Print chip according to one of the preceding claims **characterized in that** the medium chamber (11) in top view is configured rectangularly and that the admission channel (10) opens into the medium chamber (11) in such a manner, and the jet opening (13) is connected to the medium chamber (11) in such a manner that the medium flows through it essentially diagonally.

10. Print chip according to one of the preceding claims **characterized in that** the medium chamber (11), the admission channel (10), the jet opening (13) and the medium supply chamber (9) are introduced from the (100) crystal plane of the silicon crystal.

11. Print chip according to one of the preceding claims **characterized in that** the floor (15) of the recess (7) forms the membrane (14).

12. Print chip according to one of the preceding claims **characterized in that** the connecting channel (12) has at least one subchannel (28) situated vertical to the second crystal plane (24), the opening of which subchannel at the edge (25) of the print chip (2) forms the jet opening (13).

13. Print chip according to one of the preceding claims **characterized in that** the admission channel (10) has a choke point (17) or is configured as a choke.

14. Print chip according to one of the preceding claims **characterized in that** in one of the substrate portions (3,4) are situated the medium chamber (11) and the supply chamber (9) which are delimited from each other by a ridge (16) and that the admission channel (10) is configured in the other substrate portion (3,4) and is situated below the free end of the ridge (16).

15. Print chip according to one of the preceding claims **characterized by** several medium chambers (11), admission channels (10), connecting channels (12), and jet openings (13).

16. Print chip according to one of the preceding claims **characterized by** at least one heating element (29) which is situated at the exterior side of at least one of the substrate portions (3,4).

17. Print chip according to one of the preceding claims **characterized by** at least one temperature sensor (30) situated at the exterior side on at least one of the substrate portions (3,4).

18. Print chip according to one of the preceding claims **characterized in that** the membrane (14) has a thickness of approximately 20 µm to 100 µm.

19. Print chip according to claim 7 **characterized in that** -when the recesses (5 through 8,26) are let into the two substrate portions (3,4) through anistropic etching- the two substrate portions (3,4) during the etching and during the subsequent bonding are twisted by 45° to each other with reference to the (100) crystal plane lying vertical to the (100) substrate surface.

20. Use of a print chip according to one of claims 1 through 19 for jetting medium up to in excess of 1000° C in temperature.

21. Printhead which functions according to the ink-jet printing principle **characterized by** a print chip according to one of claims 1 through 19.

## Revendications

1. Puce d'impression (2) pour une tête d'impression (1) fonctionnant selon le principe d'impression à encre, comprenant au moins un creux (7) ménagé dans la puce d'impression, lequel constitue une chambre de média (11), une membrane (14) susceptible d'excursion, laquelle constitue une paroi de la chambre de média (11), un canal (10) débouchant dans la chambre de média (11) pour l'amenée d'un média liquide à éjecter à l'état brûlant et un orifice d'éjection (13) relié à la chambre de média (11), la puce d'impression (2) étant fabriquée exclusivement en silicium monocristallin et étant constituée d'au moins deux parties de substrat (3, 4) superposées, **caractérisée en ce que** le canal d'amenée (10) et un canal de liaison (12) reliant l'orifice d'éjection (13) à la chambre de média (11) sont à 45° par rapport à un deuxième plan cristallin (24, 24') perpendiculaire au plan cristallin (100) du cristal de silicium et **en ce que** la chambre de média (11) contient un angle de 45° formé avec le deuxième plan cristallin (24, 24') perpendiculaire au plan cristallin (100) et le canal d'amenée (10) et le canal de liaison (12) sont perpendiculaires à ce deuxième plan cristallin (24) et **en ce que** le plan cristallin respectif des surfaces adjacentes des parties de substrat superposées (3, 4) correspondent respectivement au plan cristallin (100).

2. Puce d'impression selon la revendication 1, **caractérisée en ce que** le canal d'amenée (10), la chambre de média (11) et l'orifice d'éjection (13) sont disposés de manière telle dans la puce d'impression (2) que le média coule en passant en alternance par les parties de substrat (3, 4).

3. Puce d'impression selon l'une des revendications précédentes, **caractérisée en ce que** se trouve, dans la puce d'impression (2), une chambre d'alimentation en média (9) à laquelle le canal d'amenée (10) est relié.

4. Puce d'impression selon l'une des revendications précédentes, **caractérisée en ce que** les surfaces de la puce d'impression, en particulier celles qui entrent en contact avec le média brûlant, sont pourvues d'un revêtement résistant aux températures élevées.

5. Puce d'impression selon l'une des revendications précédentes, **caractérisée en ce que** les surfaces de la puce d'impression, en particulier celles qui entrent en contact avec le média brûlant, sont passivées par un oxyde thermique.

6. Puce d'impression selon l'une des revendications précédentes, **caractérisée en ce que** les parties de substrat (3, 4) sont reliées entre elles de manière inséparable par le «Silicon Fusion Bonding».

7. Puce d'impression selon l'une des revendications précédentes, **caractérisée en ce que** le creux (7) pour la chambre de média (11), le canal d'amenée (10), l'orifice d'éjection (13) et la chambre d'alimentation en média (9) sont fabriqués par un procédé de gravure anisotropique à sec ou par voie humide.

8. Puce d'impression selon l'une des revendications précédentes, **caractérisée en ce que** la chambre de média (11), le canal d'amenée (10) et l'orifice d'éjection (13), vus dans le sens de l'écoulement du média, ont une section trapézoïdale ou en forme de V.

9. Puce d'impression selon l'une des revendications précédentes, **caractérisée en ce que** la chambre de média (11), vue de dessus, est de configuration rectangulaire et **en ce que** le canal d'amenée (10) débouche de manière telle dans la chambre de média (11) et l'orifice d'éjection (13) est relié de manière telle à la chambre de média (11) que celle-ci est traversée de manière sensiblement diagonale par le média.

10. Puce d'impression selon l'une des revendications précédentes, **caractérisée en ce que** la chambre de média (11), le canal d'amenée (10), l'orifice d'éjection (13) et la chambre d'alimentation en média (9) sont mis en place depuis le plan cristallin (100) du cristal de silicium.

11. Puce d'impression selon l'une des revendications précédentes, **caractérisée en ce que** le fond (15) du creux (7) constitue la membrane (14).

12. Puce d'impression selon l'une des revendications précédentes, **caractérisée en ce que** le canal de liaison (12) présente au moins un canal partiel (28) perpendiculaire au deuxième plan cristallin (24) et dont l'embouchure constitue l'orifice d'éjection (13) au bord (25) de la puce d'impression (2).

13. Puce d'impression selon l'une des revendications précédentes, **caractérisée en ce que** le canal d'amenée (10) comporte un point d'étranglement (17) ou est réalisé en tant que papillon.

14. Puce d'impression selon l'une des revendications précédentes, **caractérisée en ce que** se trouvent, dans l'une des parties de substrat (3, 4), la chambre de média (11) et la chambre d'alimentation (9), lesquelles sont délimitées l'une par rapport à l'autre par une traverse (16), et **en ce que** le canal d'amenée (10) est ménagé dans l'autre des parties de substrat (3, 4) et se trouve sous l'extrémité libre de la traverse (16).

15. Puce d'impression selon l'une des revendications précédentes, **caractérisée par** plusieurs chambres de média (11), canaux d'amenée (10), canaux de liaison (12) et orifices d'éjection (13).

16. Puce d'impression selon l'une des revendications précédentes, **caractérisée par** au moins un élément de chauffage (29) qui se trouve sur le côté extérieur d'au moins l'une des parties de substrat (3, 4).

17. Puce d'impression selon l'une des revendications précédentes, **caractérisée par** au moins un capteur de température (30) situé sur le côté extérieur d'au moins l'une des parties de substrat (3, 4).

18. Puce d'impression selon l'une des revendications précédentes, **caractérisée en ce que** la membrane (14) présente une épaisseur comprise entre environ 20 et 100 µm.

19. Puce d'impression selon la revendication 7, **caractérisé en ce que**, lorsque les creux (5 à 8, 26) sont ménagés dans les deux parties de substrat (3, 4) par gravure anisotropique, les deux parties de substrat (3, 4), lors de la gravure et de l'assemblage ultérieur, sont tournées de 45° l'une par rapport à l'autre, par rapport aux plans cristallins (100) perpendiculaires à la surface de substrat (100).

20. Utilisation d'une puce d'impression selon l'une des revendications 1 à 19 pour éjecter des médias liquides brûlants qui vont jusqu'au delà de 1000 °C.

21. Tête d'impression fonctionnant selon le principe d'impression à encre, **caractérisée par** une puce d'impression selon l'une des revendications 1 à 19.
